# FASCICULE DE BREVET EUROPEEN

(11) **EP 2 780 931 B1**
(45) Date de publication et mention de la délivrance du brevet: **24.08.2016**
(21) Numéro de dépôt: 12805608.2
(22) Date de dépôt: 19.11.2012
(51) Int. Cl.: H01L 21/288, H01L 21/768, H01L 23/48, H01L 21/67, C25D 5/02, C25D 17/00, C25D 17/06, C23C 18/16

(54) **MACHINE ADAPTÉE POUR MÉTALLISER UNE CAVITÉ D'UN SUBSTRAT SEMI-CONDUCTEUR OU CONDUCTEUR TELLE QU'UNE STRUCTURE DU TYPE VIA TRAVERSANT**
MASCHINE ZUR PLATTIERUNG EINER KAVITÄT EINES HALBLEITENDEN ODER LEITENDEN SUBSTRATS, Z. B. EINER DURCHKONTAKTIERUNG
MACHINE SUITABLE FOR PLATING A CAVITY OF A SEMI-CONDUCTIVE OR CONDUCTIVE SUBSTRATE SUCH AS A THROUGH VIA STRUCTURE

(30) Priorité: 18.11.2011 FR 1103529
(43) Date de publication de la demande: 24.09.2014
(73) Titulaire: Alchimer S.A., 91300 Massy (FR)
(72) Inventeur: RAYNAL, Frédéric, F-75012 Paris (FR)
(74) Mandataire: Regimbeau
(86) Numéro de dépôt international: PCT/EP2012/072993
(87) Numéro de publication internationale: WO 2013/072525

(56) Documents cités:
- JP-A- 2006 128 355
- US-A1- 2004 188 257
- US-A1- 2010 003 808

## Description

La présente invention concerne de manière générale la fabrication de dispositifs électroniques, tels qu'en particulier des circuits intégrés, notamment en trois dimensions, et a en particulier pour objet une machine et un procédé de métallisation d'une cavité d'un substrat semi-conducteur ou conducteur de l'électricité, telle qu'une structure du type via traversant.

L'invention trouve essentiellement application dans le domaine de la microélectronique pour la métallisation notamment par du cuivre de vias traversants (dénommés « through silicon vias » ou « through wafer vias » ou « through wafer interconnect » en anglais), clef de voûte de l'intégration des puces électroniques (dénommées « chip » ou « die » en anglais) en trois dimensions (3D) ou intégration verticale. Elle trouve également application dans d'autres domaines de l'électronique où un substrat comportant des vias traversants doit être électriquement isolé et recouvert d'une couche de cuivre. On citera dans ce contexte la fabrication d'éléments d'interconnexion dans des circuits imprimés (dénommés « printed circuit board » ou « printed wire board » en anglais) ou celle d'éléments passifs, tels que les inductances, ou électromécaniques dans des circuits intégrés ou des microsystèmes (dénommés « micro electro mechanical systems » en anglais).

Les systèmes électroniques actuels se composent, pour la plupart, de plusieurs circuits intégrés, ou composants, et chaque circuit intégré remplit une ou plusieurs fonctions. Par exemple, un ordinateur comporte au moins un microprocesseur et plusieurs circuits mémoires. Chaque circuit intégré correspond usuellement à une puce électronique dans son propre boîtier (dénommé « package » en anglais). Les circuits intégrés sont brasés ou enfichés sur, par exemple, un circuit imprimé (dénommé « printed circuit board » ou « PCB » en anglais) qui assure la connexion entre les circuits intégrés.

Le besoin permanent d'augmenter la densité de fonctionnalité des systèmes électroniques a conduit au concept dénommé "intégration en trois dimensions" ou "intégration verticale" qui se caractérise par le fait que les puces sont superposées et reliées entre elles par des interconnexions verticales. L'empilement obtenu comporte ainsi plusieurs couches ou strates de composants actifs ou puces, et constitue un circuit intégré en trois dimensions (dénommé « 3D integrated circuit » ou « 3D IC » en anglais).

Après empilement, par exemple par collage, les puces peuvent être individuellement connectées aux broches du boîtier par des fils de connexion. L'interconnexion des puces entre elles fait généralement appel à la mise en oeuvre de vias traversants.

Les technologies élémentaires nécessaires à la réalisation de circuits intégrés en trois dimensions comprennent notamment l'amincissement des tranches de silicium (dénommées "wafers" en anglais), l'alignement entre les couches, le collage des couches, la gravure et la métallisation des vias traversants au sein de chaque couche.

L'amincissement des tranches de silicium peut être réalisée avant la fabrication des vias traversants (e.g. U.S. 7,060,624; U.S. 7,148,565).

Alternativement, la gravure et la métallisation des vias peuvent être réalisées avant amincissement de la tranche de silicium (e.g. U.S. 7,060,624; U.S. 7,101,792). Dans ce cas des vias fermés ou « borgnes » (dénommés « blind vias» en anglais) sont gravés dans le silicium, puis métallisés jusqu'à la profondeur souhaitée avant d'amincir la tranche de silicium, pour obtenir ainsi des vias traversants.

La bonne conductivité électrique du cuivre et sa résistance élevée au phénomène d'électromigration, c'est-à-dire la faible migration des atomes de cuivre sous l'effet de la densité de courant électrique susceptible d'être une cause importante de défaillance, en font en particulier un matériau de choix pour la métallisation des vias traversants.

Les vias traversants des circuits intégrés 3D sont généralement réalisés de façon similaire au « procédé Damascene » utilisé dans le domaine de la microélectronique pour la fabrication d'éléments d'interconnexion des circuits intégrés, selon une succession d'étapes comportant :
- la gravure des vias dans ou au travers de la tranche de silicium ;
- le dépôt d'une couche diélectrique isolante ;
- le dépôt d'une couche barrière à la diffusion, ou « liner », servant à empêcher la migration ou diffusion du métal de remplissage, généralement du cuivre;
- le dépôt d'une couche de germination du cuivre (couche mince de cuivre, « seed layer » en anglais) permettant le remplissage du via par du cuivre malgré la forte résistivité des matériaux constitutifs de la couche barrière à la diffusion;
- le remplissage des vias par électrodéposition de cuivre ;
- le recuit du substrat, et
- l'élimination du cuivre en excès par polissage mécano-chimique.

La couche diélectrique isolante peut être inorganique (généralement constituée d'oxyde de silicium SiO2, nitrure de silicium SiN ou oxyde d'aluminium par exemple), déposée par CVD ou autre, ou organique (parylène C N ou D, polyimide, benzocyclobutène, polybenzoxazole par exemple) déposée par trempage en milieu liquide ou méthode SOG (spin-on-glass en anglais).

La couche barrière à la diffusion du cuivre est généralement constituée de tantale (Ta), titane (Ti), nitrure de tantale (TaN), nitrure de titane (TiN), alliage titane-tungstène (TiW), nitrure-carbure de tungstène (WCN) ou de combinaison de ces matériaux, et généralement déposée en phase vapeur (PVD, CVD, ALD).

Cette couche barrière peut être formée d'autres métaux comme, en particulier, un alliage à base de nickel ou de cobalt par voie electroless.

Les vias ainsi formés sont caractérisés par leur facteur de forme (« aspect ratio » en anglais), qui définit le rapport entre la profondeur et le diamètre du via. Un facteur de forme noté par exemple 10 :1 définit un via ayant un diamètre de dimension dix fois inférieure à sa profondeur.

Les étapes de dépôt de la couche barrière, de la couche de germination, de remplissage et de recuit sont communément désignées ensemble par l'expression « métallisation des vias traversants ».

Généralement, les étapes de dépôt de la couche diélectrique isolante, de la couche barrière et de la couche de germination sont réalisées par des procédés dits « par voie sèche », par dépôt physique ou chimique en phase vapeur (PVD ou « Physical Vapor Déposition », et CVD ou « Chemical Vapor Déposition » respectivement), le remplissage pouvant quant à lui être effectué par « voie humide ».

Généralement, le dépôt chimique en phase vapeur (CVD) est actuellement préféré d'un point de vue industriel pour la réalisation de la couche diélectrique isolante et de la couche barrière à la diffusion, le dépôt physique ne permettant pas d'obtenir des dépôts suffisamment conformes sur toute la profondeur du via. La couche de germination en revanche est plutôt réalisée par dépôt physique en phase vapeur, des problèmes d'adhésion et de contamination carbonée, liés aux précurseurs organiques, étant observés avec les dépôts de couche de germination par CVD.

La métallisation des vias par ces étapes par voie sèche présente cependant l'inconvénient d'être difficile à mettre en oeuvre, relativement coûteuse en raison de leurs consommables et de faible rendement. Les procédés de PVD et CVD requièrent en effet des conditions de vide poussé, des températures élevées, l'utilisation de précurseurs en phase gazeuse ou encore la production d'un plasma.

La métallisation d'un via selon cette méthode conventionnelle requière donc la mise en oeuvre de plusieurs machines différentes, généralement 3 à 5, pour déposer la couche diélectrique isolante, la couche barrière à la diffusion, la couche de germination, la couche de remplissage et le recuit. Ces machines sont en outre encombrantes, et la durée nécessaire pour métalliser les vias est très longue, cela étant dû en partie au transfert des substrats entre chaque machine.

Il a été proposé, dans le document US 2004/0188257, un procédé de lithographie sur un substrat, au cours duquel on dépose une couche de germination, puis on rince et on sèche le substrat avant de l'exposer afin de créer une couche photosensible, le tout par voie humide, à l'aide d'une unique machine. Cependant, dans ce document, la machine ne permet pas de métalliser des vias traversants (ou toute autre cavité d'un substrat semi-conducteur ou conducteur). En effet, cette machine permet uniquement la déposition d'une couche de germination dans une cavité, alors que le procédé de métallisation requiert en outre le dépôt préalable d'une couche d'isolant et d'une couche barrière. La machine décrite dans ce document n'est donc absolument pas adaptée à mettre en oeuvre à tel procédé.

Un objectif de l'invention est donc de proposer une machine adaptée pour métalliser une cavité d'un substrat semi-conducteur telle qu'une structure du type via traversant, qui soit capable de réaliser l'intégralité des étapes de métallisation rapidement avec un faible encombrement, tout en obtenant des vias métallisés de bonne qualité à faible coût en comparaison avec les procédés de métallisation par voie sèche connus.

De manière secondaire, un autre objectif de l'invention est de limiter voire d'éliminer les contacts entre les solutions chimiques et autres composants nocifs et les opérateurs.

Pour cela, l'invention propose une machine adaptée pour métalliser une cavité d'un substrat semi-conducteur ou conducteur telle qu'une structure du type via traversant, selon un procédé de métallisation comprenant les étapes consistant à :
a) déposer une couche diélectrique isolante dans la cavité,
b) déposer une couche barrière à la diffusion du métal de remplissage,
c) remplir la cavité par électrodéposition d'un métal, de préférence du cuivre, et
d) effectuer un recuit du substrat,
caractérisée en ce qu'elle comprend une série de modules en voie humide configurés pour effectuer les étapes a), b) et c) par voie humide dans un bain chimique et au moins un module complémentaire adapté pour effectuer l'étape d) de recuit du substrat, de sorte que la machine est apte à réaliser l'intégralité du procédé de métallisation de la cavité , la machine étant conforme à la revendication 1. En permettant la métallisation des vias par voie humide (à l'exception du recuit qui est effectué par voie sèche) grâce à la mise en oeuvre de modules adaptés, la machine est donc capable de réaliser l'ensemble des étapes de métallisation, tout en réduisant l'encombrement global nécessaire. Les modules de dépôt et de remplissage en milieu humide ne requièrent en effet pas la mise sous vide de la pièce ou la génération d'un plasma, et permettent en outre d'obtenir des vias présentant un dépôt continu et conforme pour une large gamme de facteurs de forme et présentant une excellente adhésion au substrat.

En accord avec l'invention :
* le substrat comprend une face active, sur laquelle est formée la cavité, et une face arrière opposée à la face active et chaque module en voie humide comprend un conteneur destiné à contenir le bain chimique, au fond duquel est disposé horizontalement un support destiné à recevoir la face arrière du substrat de sorte que la face active dudit substrat soit orientée vers le haut dans la direction opposée au fond du module.

Par horizontal, on comprendra ici bain chimique sensiblement parallèle au fond du module.

De la sorte, il est donc possible de limiter le volume de bain chimique B nécessaire pour la mise en oeuvre de chaque étape ayant lieu en voie humide, et donc l'encombrement de chaque module. En effet, le substrat semi-conducteur présentant sa face active vers le haut, seule une pellicule de la solution chimique utilisée pour le bain chimique est nécessaire pour mettre en oeuvre les différentes étapes du procédé, alors qu'en comparaison, les machines connues plongent le substrat face active vers le bas dans le bain chimique B, afin de protéger les différentes connectiques, ce qui a pour conséquence l'utilisation d'un bain chimique de grand volume afin de garantir un trempage complet du substrat et la mise en oeuvre de dispositifs de surveillance très complexes de l'évolution des bains chimiques. Les bain chimique Bs sont en outre réutilisables, de sorte que l'on réduit ainsi la quantité de consommable nécessaire par substrat semi-conducteur traité dans la machine et donc le coût global du procédé de métallisation par substrat semi-conducteurs. Enfin, cela permet de limiter la surveillance du process de manière générale : en effet, étant donnée la faible quantité de solution chimique utilisée, il est possible de renouveler le bain chimique plus souvent que dans le cas des machines par voie humide conventionnelles. La machine est donc beaucoup moins complexe.

Certains aspects non limitatifs de la machine de l'invention sont les suivants :
* le support comprend des aménagements pour maintenir le substrat en position au cours du procédé de métallisation ;
* le support comprend une protection adaptée pour protéger la face arrière du substrat ;
* les aménagements et la protection sont formés par au moins un canal adapté pour faire le vide entre le support et le substrat ;
* le conteneur des modules en voie humide comprend des parois latérale sensiblement adjacentes au support de manière à limiter le volume interne dudit conteneur ;
* elle comprend au moins un module de recuit du substrat et dans laquelle la série de modules par voie humide comprend:
   - au moins un module de pré-mouillage du substrat,
   - au moins un module de dépôt de la couche diélectrique isolante,
   - au moins un module de rinçage et de séchage,
   - au moins un module d'activation de la couche barrière à la diffusion,
   - au moins un module de dépôt de la couche barrière à la diffusion, et
   - au moins un module de remplissage par électrodéposition d'un métal ;
* elle comprend au moins six modules de recuit du substrat et dans laquelle la série de modules par voie humide comprend:
   - au moins deux modules de pré-mouillage du substrat,
   - au moins trois modules de dépôt de la couche diélectrique isolante,
   - au moins un module de rinçage et de séchage,
   - au moins un module d'activation de la couche barrière à la diffusion,
   - au moins un module de dépôt de la couche barrière à la diffusion,
   - au moins huit modules de remplissage par électrodéposition d'un métal ;
* les modules de pré-mouillage, de dépôt de la couche diélectrique isolante, de rinçage et de séchage, d'activation, de dépôt de la couche barrière à la diffusion et de remplissage comprennent chacun des moyens adaptés pour déplacer verticalement le substrat entre une position haute, dans laquelle le support est adjacent à une ouverture du module afin de permettre le placement du substrat sur le support et une position basse, dans laquelle le support est baissé dans le module de manière à permettre son traitement par voie humide ;
* les modules de dépôt de la couche diélectrique isolante, les modules d'activation de la couche barrière à la diffusion, les modules de dépôt de la couche barrière à la diffusion et/ou les modules de remplissage comprennent en outre un dispositif de rinçage et de séchage du substrat ;
* le dispositif de rinçage et de séchage comprend un bras adapté pour déposer un fluide de rinçage sur la face active du substrat ;
* le dispositif de rinçage et de séchage comprend en outre un moteur adapté pour mettre le support en rotation autour d'un axe central dudit support et/ou une buse adaptée pour envoyer un gaz inerte sur le substrat pour sécher le substrat ;
* les modules de dépôt de la couche diélectrique isolante, les modules d'activation de la couche barrière à la diffusion, les modules de dépôt de la couche barrière à la diffusion et/ou les modules de remplissage sont disposés dans un réceptacle adapté pour recevoir le fluide de rinçage lors de la rotation du support ;
* les modules de pré-mouillage, de dépôt de la couche diélectrique isolante, d'activation, de dépôt de la couche barrière à la diffusion et de remplissage comprennent en outre au moins des moyens adaptés pour permettre l'évacuation au moins partielle du bain chimique ;
* les moyens comprennent un tuyau s'étendant depuis un couvercle du module adapté pour aspirer au moins partiellement le bain chimique, et/ou une buse adaptée pour aspirer au moins partiellement le bain chimique ;
* elle comprend en outre un réceptacle adapté pour recevoir une cassette logeant une pluralité de substrats, et au moins un robot pour extraire successivement les substrats de la cassette et les transférer successivement d'un module à un autre pour métalliser au moins une cavité de chacun desdits substrats ;
* chaque module de recuit comprend :
   - un conteneur, au fond duquel sont disposées une plaque formant source froide et une plaque formant source chaude destinées à recevoir successivement le substrat,
   - un robot interne configuré pour faire passer le substrat de la source froide à la source chaude, et inversement, et
   - des moyens adaptés pour remplacer un gaz régnant dans le conteneur par du gaz inerte, et inversement ;
* chaque module de dépôt de la couche diélectrique isolante comprend:
   - un conteneur destiné à contenir le bain chimique, ici un électrolyte, au fond duquel est disposé le support configuré pour recevoir le substrat,
   - une anode constituée d'un métal inerte et disposée dans le conteneur,
   - un éclairage comprenant une source émettant des rayons lumineux et un moyen pour homogénéiser les rayons lumineux sur l'ensemble de la surface du substrat, de manière à activer la surface du substrat,
   - une alimentation électrique comprenant des moyens de connexion au substrat et à l'anode pour polariser la surface du substrat à un potentiel électrique permettant la réaction électrochimique, et
   - un joint d'étanchéité, adapté pour isoler l'alimentation électrique de l'électrolyte.
* chaque module de dépôt de la couche diélectrique isolante comprend en outre des moyens de rotation de l'anode par rapport au support ;
* chaque module de remplissage comprend un moteur adapté pour mettre le support en rotation autour d'un axe central dudit support pour évacuer une partie du bain chimique ;
* chaque module de remplissage est en outre adapté pour déposer sur la couche barrière à la diffusion une couche de germination formée dans le même métal que la couche de remplissage ;
* chaque module de remplissage comprend :
   - un conteneur destiné à contenir le bain chimique, ici un électrolyte, au fond duquel est disposé le support configuré pour recevoir le substrat,
   - une anode, constituée d'un métal inerte ou d'un métal identique à celui qui est déposé au cours du remplissage de la cavité,
   - une alimentation électrique comprenant des moyens de connexion à la couche barrière de diffusion et à l'anode pour polariser la surface de la couche barrière de diffusion à un potentiel électrique permettant la réaction électrochimique, et
   - un joint d'étanchéité, adapté pour isoler le l'alimentation électrique de l'électrolyte ;
* chaque module de remplissage comprend en outre des moyens de rotation de l'anode par rapport au support ;
* chaque module d'activation et/ou chaque module de dépôt de la couche barrière à la diffusion comprennent :
   - un conteneur destiné à contenir le bain chimique, au fond duquel est disposé le support configuré pour recevoir le substrat,
   - un premier chauffage, adapté pour chauffer le substrat à une température de l'ordre de 50°C à 80°C, de préférence 65°C, ledit premier chauffage pouvant être constitué par le support configuré pour recevoir le substrat, et/ou un deuxième chauffage, adapté pour chauffer le bain chimique active insertion dans le conteneur à une température de l'ordre de 50°C à 80°C, de préférence 65°C,
   - un émetteur d'ultrasons ou de mégasons, et
   - un joint d'étanchéité, adapté pour isoler une zone périphérique du substrat du bain chimique ; et
* chaque module de pré-mouillage comprend :
   - un conteneur destiné à contenir le bain chimique, ici de l'eau déionisée, au fond duquel est disposé le support configuré pour recevoir le substrat, et
   - une pompe, adaptée pour faire le vide dans le conteneur.

Selon un deuxième aspect, l'invention propose également un procédé de métallisation d'une cavité d'un substrat semi-conducteur ou conducteur telle qu'une structure du type via traversant, comprenant les étapes consistant à :
a) déposer une couche diélectrique isolante,
b) déposer une couche barrière à la diffusion du métal de remplissage,
c) remplir la cavité par électrodéposition d'un métal, de préférence du cuivre, et
d) effectuer un recuit du substrat,
caractérisé en ce que lesdites étapes sont intégralement réalisées avec une machine confirme à l'invention.

Certains aspects préférés mais non limitatifs du procédé selon l'invention sont les suivants :
* il comprend successivement les sous-étapes suivantes :
   (i) pré-mouillage du substrat,
   (ii) dépôt d'une couche diélectrique isolante,
   (iii) rinçage et séchage du substrat,
   (iv) recuit du substrat,
   (v) activation de la couche barrière à la diffusion du métal,
   (vi) rinçage et séchage du substrat,
   (vii) dépôt de la couche barrière à la diffusion du métal de remplissage,
   (viii) rinçage et séchage du substrat,
   (ix) pré-mouillage du substrat,
   (x) remplissage de la cavité par électrodéposition du métal,
   (xi) rinçage et séchage du substrat, et
   (xii) recuit du substrat ;
* il comprend en outre une étape de recuit du substrat entre l'étape de rinçage et séchage du substrat (viii) et l'étape de pré-mouillage du substrat (ix) ;
* les étapes de rinçage et séchage du substrat (iii), (vi) et/ou (viii) sont réalisées dans le même module que les étapes de dépôt (ii), activation (v) et/ou dépôt (vii) respectivement.
* au début de chaque étape (i), (ii), (iv), (v), (vii), et (ix), le substrat est fixé sur un support disposé dans le module correspondant à ladite étape au moyen d'un robot ;
* suite à la fixation du substrat sur le support, le procédé comprend en outre une étape au cours de laquelle le support est baissé dans le module et le module est fermé ; et
* à la fin de chaque étape (i), (ii), (iv), (v), (vii), et (ix), le module est ouvert et le support est relevé de telle sorte que le support se trouve adjacent à l'ouverture du module pour que le robot puisse extraire le support du module.

D'autres caractéristiques, buts et avantages de la présente invention apparaîtront mieux à la lecture de la description détaillée qui va suivre, faite en référence aux figures annexées données à titre non limitatif et sur lesquelles :

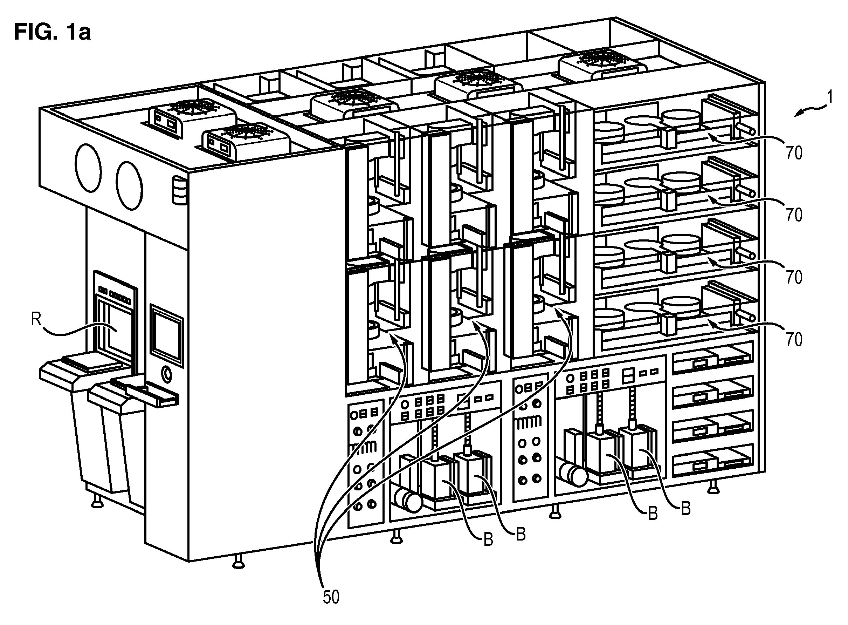

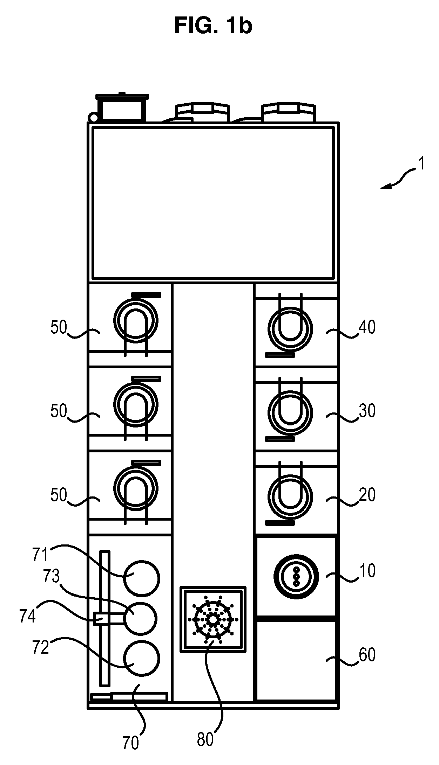

Les figures 1a et 1 b représentent respectivement une vue générale en perspective et une vue en coupe d'un exemple de machine conforme à l'invention ;

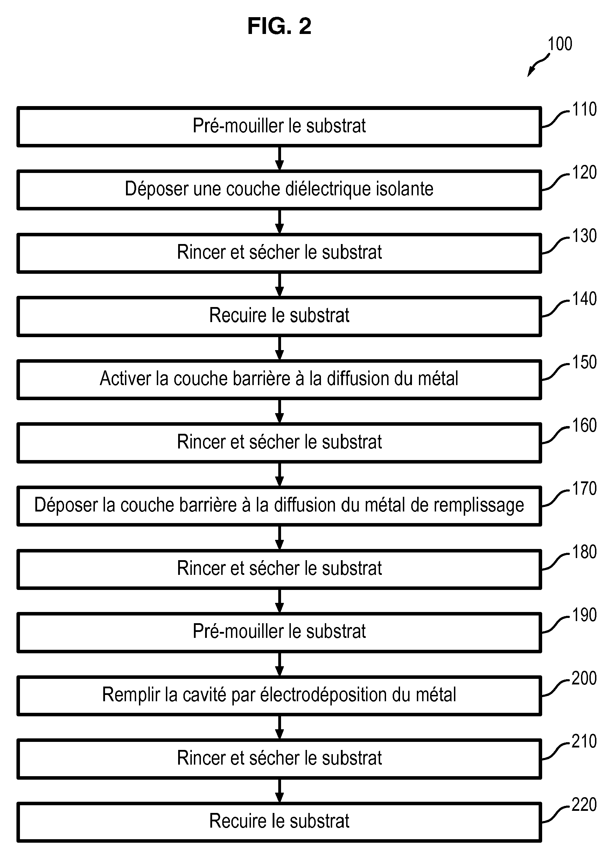

La figure 2 est un organigramme représentant différentes étapes d'un procédé de métallisation conforme à l'invention,

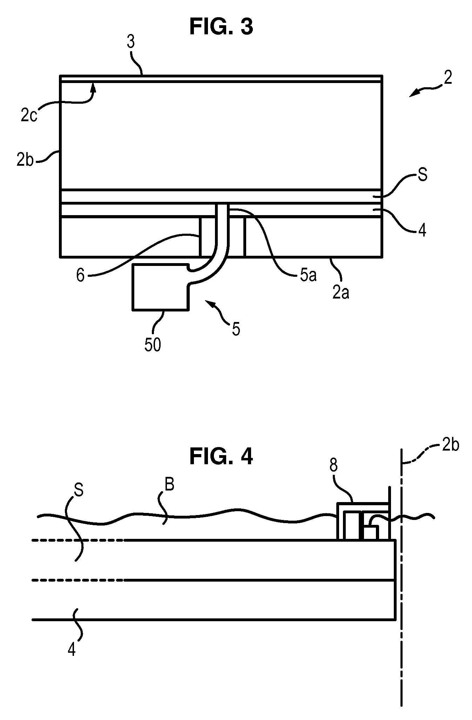

La figure 3 représente de manière générale un module en voie humide pouvant de la machine des figures 1 a et 1 b, et
La figure 4 représente une vue en détail d'un exemple de connectique d'un module de dépôt d'une couche diélectrique isolante ou de remplissage.

Nous allons à présent décrire une machine pour la métallisation d'une cavité, par exemple d'un via, d'un substrat S semi-conducteur conforme à l'invention.

Le substrat S peut par exemple être une plaque de silicium de 200 mm à 300 mm de diamètre, présentant au moins un via.

Dans ce qui suit, elle peut en particulier être mise en oeuvre pour la métallisation d'un via selon le procédé décrit dans le document FR 2 933 425 et dans la demande FR 10 54668 au nom de la Demanderesse. On obtient alors un substrat S conducteur ou semi-conducteur dans lesquels sont réalisés des vias, recouvert d'une couche diélectrique isolante, d'une couche barrière à la diffusion et d'une couche de germination. Il ne reste alors plus qu'à remplir les vias par électrodéposition, puis effectuer un recuit de l'ensemble.

Ceci n'est cependant pas limitatif, et d'autres procédés de métallisation de cavités d'un substrat S conducteur ou semi-conducteur par voie humide peuvent être utilisés pour le dépôt des couches d'isolant électrique, barrière à la diffusion et de germination.

Par ailleurs, on notera qu'une telle machine est adaptée pour être utilisée de préférence dans une salle blanche conforme aux standards actuels pour la fabrication de composants tels que produits par l'industrie de la micro-électronique.

Une machine conforme à l'invention comprend une série de modules configurés pour déposer les couches diélectrique isolante et barrière et remplir la cavité par voie humide dans un bain chimique B, et au moins un module adapté pour effectuer le recuit du substrat S semi-conducteur.

Plus précisément, la machine peut comprendre :
- au moins un module de pré-mouillage 10 du substrat S,
- au moins un module de dépôt de la couche diélectrique isolante 20,
- au moins un module de rinçage et de séchage 60,
- au moins un module d'activation de la couche barrière à la diffusion du métal de remplissage 30,
- au moins un module de dépôt de la couche barrière à la diffusion 40,
- au moins un module de remplissage par électrodéposition du métal, de préférence du cuivre 50, et
- au moins un module de recuit 70 du substrat S.

Etant donnée la vitesse de chacune de ces étapes, afin d'optimiser le rendement de la machine, celle-ci peut comprendre de préférence :
- deux modules de pré-mouillage 10 du substrat S,
- trois modules de dépôt de la couche diélectrique isolante 20,
- un module de rinçage et de séchage 60,
- un module d'activation de la couche barrière à la diffusion du métal de remplissage 30,
- un module de dépôt de la couche barrière à la diffusion 40,
- huit modules de remplissage par électrodéposition du métal, de préférence du cuivre 50, et
- six modules de recuit 70 du substrat S,
   soit 22 modules, son rendement permettant alors de métalliser au moins dix substrats S par heure.

On comprendra que la machine 1 qui fait l'objet de l'invention est apte à réaliser l'intégralité des étapes de métallisation. Néanmoins, il est possible de ne réaliser qu'une partie de ces étapes, par exemple en partant d'un substrat S présentant des vias sur lesquels une couche de diélectrique déposé par voie sèche, par exemple une couche de SiO₂, a déjà été déposée, voire même le cas échéant une couche barrière à la diffusion du métal de remplissage (généralement du cuivre).

Par ailleurs, la machine 1 étant constituée de modules distincts, celle-ci peut également fonctionner sans les modules permettant de réaliser les couches diélectriques isolantes voire même sans les modules permettant de réaliser la couche barrière de diffusion, sans pour autant sortir de l'esprit de l'invention.

Conformément à l'invention, seul le module de recuit 70 du substrat S fonctionne par voie sèche, les autres étant adaptés pour réaliser des étapes par voie humide.

En particulier, les modules par voie humide, à savoir les modules de pré-mouillage 10, de dépôt des couches diélectriques isolantes 20 et barrière à la diffusion 40, d'activation de la barrière 30 et de remplissage 50, comprennent un conteneur 2 présentant un fond 2a, des parois latérales 2b 2b et une ouverture 2c fermée par un couvercle 3. Ici, les parois 2b sont représentées de forme globalement cylindrique, mais ceci n'est aucunement limitatif.

Le conteneur 2 est destiné à contenir le bain chimique B et l'ensemble des connectiques et moyens propres à chaque module. Il comprend en outre un support 4 (« stage » en anglais), configuré pour recevoir et maintenir en position le substrat S au cours de l'étape correspondante du procédé de métallisation. Le support 4 est disposé parallèlement au fond 2a du conteneur 2, dans une position globalement horizontale.

Par exemple, le support 4 est équipé de moyens d'aspiration 5, adaptés pour faire le vide avec une face du substrat S, de manière à le maintenir en position. De tels moyens d'aspiration peuvent notamment avoir la forme d'un ou plusieurs canaux traversants 5a, dont une première extrémité est reliée à une pompe à vide 5a tandis que leur deuxième extrémité débouche à la surface du support 4 configurée pour recevoir le substrat S, par exemple dans une zone centrale de celui-ci.

Avantageusement, le substrat S (qui présente une face active sur laquelle débouche(nt) le(s) via(s), qui est adaptée pour recevoir les différentes couches de métallisation, et une face arrière opposée à la face active) est posé sur le support 4 de telle sorte que sa face active soit orientée vers le haut, dans la direction opposée au fond 2a du conteneur 2. C'est donc la face arrière du substrat S qui est en contact avec le support 4.

Ce choix particulier de l'orientation du substrat S dans le conteneur 2 permet à la fois de limiter la quantité de consommables utilisée, et donc le coût global de métallisation par substrat S traité, ainsi que l'encombrement de la machine par rapport au cas où le substrat S est présenté face active vers le support 4.

En effet, dans le cas des cellules par voie humide conventionnelles, où le substrat S est présenté avec sa face active orientée vers le bas ou orientée verticalement et plongé dans cette position dans le bain chimique B pour la réalisation de l'étape correspondante, un volume de bain chimique B plus important est nécessaire si l'on souhaite garantir que l'intégralité du substrat S soit mouillée par le bain chimique B. Ainsi, si les modules étaient agencés pour recevoir le substrat S face active vers le bas, conformément aux cellules conventionnelles, la quantité de consommables utilisée aurait été trop importante pour que la machine soit rentable par rapport aux machines connues aujourd'hui, et la surveillance des bains aurait été beaucoup plus complexe à mettre en oeuvre.

En comparaison, ici, l'orientation spécifique de la face active du substrat S vers le haut, en direction l'ouverture du conteneur 2, permet de limiter le bain chimique B à une fine pellicule sur la face active puisque celle-ci s'étend horizontalement, tout en garantissant un mouillage suffisant pour la réalisation des étapes subséquentes par voie humide du procédé de métallisation.

Afin d'optimiser encore le volume de solution utilisé, les dimensions du conteneur 2 sont elles-mêmes adaptées de manière à limiter le volume nécessaire pour recouvrir la face active du substrat S. Pour cela, les parois du conteneur 2 peuvent par exemple être ajustées aux dimensions du substrat S, de manière à ne laisser qu'un faible espace entre la tranche du substrat S et le conteneur 2. Le conteneur 2 de chaque module est donc choisi de préférence de telle sorte qu'il soit suffisamment grand pour pouvoir d'une part contenir à la fois le support 4, un substrat S, les connectiques et le bain chimique B associés à l'étape correspondante du procédé de métallisation (e. g. des contacts électriques, un joint d'étanchéité, un émetteur ultrason, un électrolyte, etc.) tout en étant réduit au strict nécessaire afin de limiter l'encombrement global de la machine ainsi que la quantité de consommables utilisée.

Par exemple, pour un substrat S formé d'une plaque de silicium de 200 mm environ de diamètre, il est possible d'utiliser entre 1 L et 1,5L d'eau déionisée et 60 mL à 300 mL de bains chimiques B seulement par plaque de silicium en ajustant les dimensions internes du conteneur 2 aux dimensions des plaques traitées, et ce sans surveiller nécessairement les bains chimiques B.

Ce choix particulier de l'orientation du substrat S sur le support 4 n'était cependant pas évident au vu des différentes étapes réalisées lors de la métallisation par voie humide. Celles-ci requièrent en effet tout une connectique, que nous verrons plus en détails dans la suite de cette description, reliée généralement à la périphérie du substrat S et devant à tout prix être protégée du bain chimique B sous peine d'endommagements pour le bon déroulement du procédé.

De plus, les bains chimiques B utilisés au cours des différentes étapes de la métallisation des vias sont généralement réutilisables à plusieurs reprises. A cet effet, on rappelle que les cellules conventionnelles comportent généralement tout une série de moyens de surveillance des bains chimiques B permettant de mesurer des paramètres de mesure prédéterminés (pH, quantités d'une substance chimique donnée, etc.), afin de suivre leur évolution et le cas échéant d'ajuster le bain chimique B par ajout de produits supplémentaires, ou de le remplacer par un nouveau bain chimique B.

Il est en effet nécessaire d'optimiser le nombre de cycles d'utilisation des bains chimiques B afin de limiter la quantité de consommables par substrat S pour réduire les coûts.

Or ici, comme nous l'avons vu plus haut, le volume du bain chimique B peut être réduit considérablement en positionnant la face arrière du substrat S sur le support 4. Par conséquent, la surveillance des bains chimiques B peut être grandement simplifiée, dans la mesure où les bains chimiques B peuvent être renouvelés plus souvent sans que le coût global par substrat S s'en trouve réellement affecté. Par exemple, dans l'exemple décrit précédemment, pour l'ensemble des 22 modules par voie humide, seuls quelques paramètres physiques sont surveillés, tels que le pH, la température ou les débits des bains chimiques B. Par ailleurs, cette surveillance peut être réalisée indifféremment en ligne, c'est-à-dire par des moniteurs disposés directement dans la machine, ou hors ligne, en laboratoire.

A cet effet, la machine étant réalisée sous forme de modules distincts, les prélèvements peuvent aussi bien être réalisés au niveau de chaque module, de l'alimentation en bain desdits modules, des bidons contenant les bains chimiques B destinés à être utilisés lors du procédé de métallisation et/ou de réservoirs intermédiaires dans lesquels sont faits les mélanges des différentes solutions pour obtenir le bain chimique B.

En variante, les bains chimiques B peuvent être renouvelés systématiquement au bout d'un nombre de cycle déterminé en fonction du type de bain utilisé. Typiquement, dans le module de pré-mouillage, l'eau déionisée est renouvelée après chaque cycle, tandis que dans le module d'activation, le bain chimique B est renouvelé tous les dix cycles environ. La machine est donc beaucoup plus simple qu'une machine comprenant un système complexe de surveillance des bains, tout en permettant si nécessaire une surveillance hors ligne par prélèvements à différents endroits de la machine.

Un autre avantage du positionnement vers le haut de la face active est que le support 4 peut protéger la face arrière des contaminations par le bain chimique B.

Nous allons à présent décrire des exemples de réalisation des modules formant une machine conforme à l'invention. Nous prendrons comme exemple de substrat S une plaque de silicium comprenant une série de vias. Le support 4 est alors de forme et de dimensions sensiblement identiques, de manière à limiter l'encombrement du module et à protéger l'intégralité de la face arrière de la plaque. Ceci n'est cependant pas limitatif et d'autres types de substrats S peuvent être envisagés.

De manière générale, et comme nous l'avons vu plus haut, chacun des modules comprend un conteneur 2, formé d'un fond 2a, de parois latérales 2b et d'une ouverture fermée par un couvercle 3, au fond 2a duquel est disposé le support 4 destiné à recevoir et à maintenir le substrat S en position.

Avantageusement, le support 4 des modules en voie humide comprend des moyens adaptés pour déplacer verticalement le support 4 entre une première position, dite basse, qui est adjacente au fond 2a du conteneur 2 et dans laquelle a lieu l'étape associée du procédé de métallisation, et une deuxième position, dite haute, qui est adjacente à l'ouverture du module et dans laquelle le substrat S est notamment positionné sur le support 4 puis retiré de celui-ci, de préférence de manière automatisée par un robot 80.

Le module de pré-mouillage 10 a pour objectif de forcer de l'eau déionisée à entrer dans le via afin de permettre son revêtement ultérieur par la couche d'isolant. Pour cela, il comprend une source d'eau, de préférence déionisée, connectée à des moyens configurés pour introduire l'eau dans le conteneur 2, ainsi qu'une pompe adaptée pour mettre le substrat S sous vide, typiquement à une pression de l'ordre de 1 à 10 mbar.

Le module de dépôt de la couche diélectrique isolante 20 quant à lui comprend une anode disposée dans le conteneur 2, un éclairage comprenant une source émettant des rayons lumineux et un moyen pour homogénéiser les rayons lumineux sur l'ensemble de la surface du substrat S de manière à activer la surface du substrat S, et un dispositif de mise en contact électrique 7 physiquement isolé du bain chimique B, qui est ici un électrolyte.

L'anode est de préférence constituée d'un métal inerte (du titane recouvert de platine par exemple), et peut être montée à rotation par rapport au support 4 de manière à parcourir la périphérie du substrat S lors de la rotation. Ici, dans le cas d'une plaque circulaire, l'anode est donc montée à rotation autour de l'axe de symétrie de la plaque et du support 4.

Par exemple, l'anode, l'éclairage et l'alimentation électrique du module de dépôt peuvent être conformes au module décrit dans le document FR 2 943 688 au nom de la Demanderesse.

Par ailleurs, le dispositif de mise en contact électrique présente des moyens de connexion 7 au substrat S et à l'anode pour polariser la surface du substrat S à un potentiel électrique permettant la réaction électrochimique, et est isolé de l'électrolyte par un joint d'étanchéité 8. Il peut s'agir notamment de contacts électriques 7 de forme annulaire discontinus le long de la périphérie du substrat S de manière à fournir une alimentation du substrat S en plusieurs points de contact disposés de manière régulière sur celle-ci. Ces contacts 7 sont en outre protégés tout le long de la périphérie du substrat S par un joint torique d'étanchéité 8, permettant d'isoler les contacts de l'électrolyte, tout en permettant leur connexion à une alimentation électrique. De préférence, l'étendue radiale du joint torique 8 (par rapport à la périphérie du substrat) est de l'ordre de 2 à 4 mm environ.

De la sorte, cette configuration du module autorise donc, grâce notamment au joint d'étanchéité, le positionnement du substrat S sur le support 4 avec sa face active en haut, sans risquer d'endommager la connectique électrique 7.

Enfin, l'électrolyte B, qui comprend au moins deux solutions chimiques, est réalisé en amont du module, dans un mélangeur, avant d'être introduit dans le module. Par exemple, la machine 1 peut comprendre un système de pompes et de doseurs adaptés pour prélever les quantités nécessaires de chacune des solutions dans des barils B spécifiques et les introduire dans le mélangeur, qui les mélange selon un ratio prédéfini afin d'obtenir l'électrolyte B utilisé pour le dépôt de la couche diélectrique isolante, avant de l'introduire dans le conteneur 2.

Le module d'activation 30 et le module de dépôt de la couche barrière de diffusion au métal de remplissage 40 comprennent des moyens adaptés pour chauffer le substrat S et/ou le bain chimique B à une température comprise entre 50°C et 80°c, de préférence de l'ordre de 65°C, un émetteur d'ultrasons ou de mégasons, ainsi qu'un joint d'étanchéité. On pourra notamment se référer à aux demandes WO 2011/039310 et WO 2011/029860 au nom de la Demanderesse pour plus de détails.

Selon une forme de réalisation préférée, le substrat S est chauffé directement à la température voulue par le support 4 sur lequel il est disposé, et le bain chimique B est chauffé préalablement à son introduction dans le conteneur 2.

Par ailleurs, le joint d'étanchéité a pour objectif d'isoler une zone périphérique du substrat S, sur une étendue radiale de l'ordre de 2 à 4 mm.

A nouveau, le bain chimique B peut comprendre au moins deux solutions chimiques différentes, de sorte que le module est connecté en amont à un mélangeur associé, adapté pour mélanger les solutions préalablement à leur introduction dans le module.

Chacun des modules de dépôt de la couche diélectrique isolante 20, d'activation de la barrière à la diffusion du métal de remplissage 30 et de dépôt de ladite barrière 40 peut en outre comprendre des moyens de rinçage et de séchage du substrat S. Pour cela, le module comprend en outre une cuve externe, entourant le conteneur 2, au moins une buse adaptée pour envoyer un fluide de rinçage, ici de l'eau déionisée, sur le substrat S et des moyens adaptés pour mettre le support 4 en rotation autour de l'axe de symétrie de celui-ci.

La buse adaptée pour envoyer l'eau déionisée sur le substrat S peut par exemple être fixée sur un bras monté à rotation par rapport au module, et adaptée pour envoyer l'eau distillée dans une zone centrale du substrat S.

De la sorte, lorsque l'étape du procédé de métallisation s'achève dans le module, le couvercle 3 du module s'ouvre et le support 4 est amené en position haute. L'eau est ensuite envoyée sur le substrat S afin de le rincer, puis le substrat S est mis en rotation afin d'évacuer l'eau et de sécher le substrat S.

De manière optionnelle, le support 4 peut être mis en rotation une première fois afin d'effectuer un rinçage à l'eau, de manière à évacuer le reste de bain présent en surface du substrat S dans la cuve.

Par ailleurs, selon une forme de réalisation préférée, le substrat S et optionnellement le support 4 font saillie hors du conteneur 2 en position haute afin de faciliter l'évacuation de l'eau dans la cuve.

Le module de remplissage par électrodéposition du métal, de préférence du cuivre, comprend quant à lui une anode disposée dans le conteneur 2 et un dispositif de mise en contact électrique physiquement isolé du bain chimique B, qui est ici un électrolyte.

L'anode est de préférence constituée d'un métal inerte ou d'un métal identique au métal déposé (ici du cuivre) et peut être montée à rotation par rapport au support 4 de manière à parcourir la périphérie du substrat S lors de la rotation. Ici, dans le cas d'une plaque circulaire, l'anode est donc montée à rotation autour de l'axe de symétrie de la plaque et du support 4.

Par ailleurs, le dispositif de mise en contact électrique peut être identique à celui du module de dépôt de la couche diélectrique isolante, et présente des moyens de connexion au substrat S et à l'anode pour polariser la surface de la couche barrière de diffusion au cuivre à un potentiel électrique permettant la réaction électrochimique. Il est en outre isolé de l'électrolyte par un joint d'étanchéité, qui peut être torique comme décrit précédemment, formant un canal annulaire autour de contacts électriques et s'étendant sur une distance radiale de l'ordre de 3 à 5 mm environ.

Le module de remplissage est adapté pour déposer la couche de germination et la couche de remplissage du via. En variante, comme détaillé dans la demande FR 10 54668 déposée le 11 juin 2010 au nom de la Demanderesse, le module est également adapté pour remplir le via par électrodéposition du cuivre sans dépôt préalable de la couche de germination. On pourra se référer à cette demande pour plus de détails concernant le procédé et le module en lui-même.

Par ailleurs, le module de remplissage peut en outre comprendre des moyens de séchage adaptés pour mettre le support 4 en rotation autour de l'axe de symétrie de celui-ci, ainsi qu'une cuve externe, entourant le conteneur 2. De la sorte, à la fin de l'étape de remplissage, le couvercle 3 du module s'ouvre et le support 4 est amené en position haute. Le substrat S est alors mis en rotation afin d'évacuer le reste d'électrolyte avant d'être amené au module suivant.

De manière optionnelle, le module de remplissage peut également comprendre des moyens de rinçage comme décrits ci-avant. Cela n'est cependant pas obligatoire, dans la mesure où le substrat S est ensuite amené dans le module de rinçage et de séchage.

Afin de pouvoir réutiliser le bain chimique B à plusieurs reprises et d'éviter tout contact entre le bain électrochimique et les différentes connectiques reliées au substrat S (et notamment les dispositifs de mise en contact électrique), les modules de pré-mouillage, de dépôt de la couche diélectrique isolante, d'activation de la couche barrière à la diffusion du métal, de dépôt de la couche barrière à la diffusion du métal et de remplissage comprennent en outre au moins des moyens d'évacuation adaptés pour permettre l'évacuation au moins partielle du bain chimique B.

En effet, même lorsque le support 4 est placé en position haute avant d'être saisi par exemple par la pince d'un robot 80, une pellicule du bain chimique B reste à la surface du substrat S. En raison de la mouillabilité du bain chimique B, il est toutefois très difficile de retirer les connectiques du substrat S sans risquer de les mouiller avec le bain.

Les moyens d'évacuation comprennent par exemple un tuyau s'étendant depuis un couvercle 3 du module et adapté pour aspirer au moins partiellement le bain chimique B. Le tuyau peut par exemple être monté de manière mobile dans le couvercle 3 entre une position escamotée, dans laquelle le tuyau est rétracté vers le couvercle 3 et ne gêne pas la manipulation du substrat S ni le procédé de métallisation, et une position d'aspiration, dans laquelle l'extrémité libre tuyau est amenée vers la face active du substrat S alors que celui-ci se trouve encore en position basse, à faible distance de celle-ci (de l'ordre de 0.1 mm à 3 mm) afin d'aspirer un maximum du bain chimique B sans pour autant boucher le tuyau. Le tuyau est alors capable d'aspirer une majeure partie du bain chimique B soit pour réutilisation, soit pour remplacement par un bain neuf.

En variante, les moyens d'évacuation peuvent également comprendre une buse adaptée pour aspirer au moins partiellement le bain chimique B. La buse peut par exemple être fixée sur l'extrémité libre d'un bras monté à pivotement sur le module.

Dans tous les cas, seule une très fine pellicule, de l'ordre de 0.3 mm à 3 mm d'épaisseur reste alors sur le substrat S. Toutefois, la tension superficielle entre la fine pellicule de bain chimique B restant et le substrat S permet de retirer les connectiques sans risquer de les contaminer.

On notera que, lorsque le substrat S est plongé face active vers le bas dans le bain chimique B, comme c'est le cas dans les machines conventionnelles, le problème lié à la déconnexion des connectiques ne se pose pas. En effet, le substrat S est sorti directement avec la connectique.

Le module de rinçage et de séchage comprend une alimentation en fluide de rinçage, ici de l'eau déionisée, adaptée pour alimenter une buse adaptée pour envoyer l'eau déionisée sur le substrat S et des moyens adaptés pour mettre le support 4 en rotation autour de l'axe de symétrie de celui-ci.

La buse peut par exemple être fixée sur l'extrémité libre d'un bras monté à rotation sur le module.

Le module comprend en outre une buse adaptée pour envoyer un gaz inerte, généralement de l'azote, sur la face active du substrat S afin de permettre un séchage complet de sa surface.

Enfin, le module de recuit 70 comprend, de manière conventionnelle, une plaque formant source froide 71 (« cold plate » en anglais) et une plaque formant source chaude 72 (« hot plate » en anglais), adaptées pour recevoir la face arrière du substrat S, ainsi qu'un robot interne 70 adapté pour transférer le substrat S d'une plaque à l'autre, et des moyens permettant des moyens 74 adaptés pour remplacer un gaz régnant dans le conteneur 2 par du gaz inerte, et inversement.

En fonctionnement, le robot interne 73 saisit, de préférence par la tranche, le substrat S et le place dans le module de recuit 70, sur la plaque formant source froide 71. Le conteneur 2 est alors fermé, et l'atmosphère remplacée par un gaz inerte. Le robot interne 73 place alors le substrat S sur plaque formant source chaude 72 et la laisse recuire pendant une durée déterminée, généralement quelques minutes. Enfin, le robot 73 repositionne le substrat S sur la plaque formant source froide 71 pendant une durée déterminée, généralement quelques minutes, l'atmosphère inerte est évacuée et le module 70 est ouvert.

Selon une forme de réalisation préférée, la machine 1 est exhaustée, c'est-à-dire que l'ensemble des gaz sont évacués en dehors de la salle blanche via un système de tuyauterie, de manière à éviter toute exposition à des opérateurs.

Par ailleurs, la machine 1 est adaptée pour automatiser l'ensemble des étapes du procédé de métallisation 100, afin de limiter, voire d'éliminer, tout risque de contact entre l'opérateur et les bains chimiques B ou les substrats S.

Pour cela, la machine 1 peut par exemple comprendre un réceptacle R adapté pour recevoir une cassette (non visible sur les figures) logeant une pluralité de substrats S, et au moins un robot pour extraire successivement les substrats S de la cassette et les transférer successivement d'un module à un autre pour la mise en oeuvre des étapes de métallisation de vias de chacun desdits substrats S semi-conducteurs.

Afin de faciliter le transfert des substrats S entre les modules entre chaque étape du procédé de métallisation 100, le robot 80 peut comprendre par exemple une pince, présentant une surface plane et adaptée pour saisir le substrat S par sa face inférieure à la manière d'une spatule. Celle-ci peut en outre être munie de moyens de fixation, tels que des buses adaptées pour faire le vide, de manière à garantir la bonne tenue du substrat S sur la pince.

Par ailleurs, on notera que le placement en position haute des support 4s des modules facilite le positionnement correct du substrat S sur les support 4s par pince.

Enfin, les modules peuvent être disposés de part et d'autre d'un rail, sur lequel le robot 80 est apte à se déplacer, et être répartis sur au moins deux étages afin de réduire l'encombrement de la machine.

Une machine conforme à l'invention peut alors présenter des dimensions de l'ordre de 2 m x 5 m pour 3 m de hauteur.

Nous allons à présent décrire un procédé de métallisation d'une cavité d'un substrat S semi-conducteur ou conducteur telle qu'une structure du type via traversant conforme à l'invention.

Un procédé conforme à l'invention comprend les étapes consistant à:
a) déposer une couche diélectrique isolante,
b) déposer une couche barrière à la diffusion du métal de remplissage,
c) remplir la cavité par électrodéposition d'un métal, de préférence du cuivre, et
d) effectuer un recuit du substrat S.

Ces étapes sont de préférence toutes réalisées au moyen d'une machine conforme à l'invention. Cependant, il est possible de ne réaliser que les étapes b), c) et d), ou le cas échéant c) et d), si le substrat S comprend déjà une couche diélectrique isolante, ou une couche diélectrique isolante et une couche barrière à la diffusion du métal.

Plus précisément, le procédé 100 peut comprendre les étapes suivantes :
(i) pré-mouiller le substrat S 110,
(ii) déposer une couche diélectrique isolante 120,
(iii) rincer et sécher le substrat S 130,
(iv) recuire le substrat S 140,
(v) activer la couche barrière à la diffusion du métal 150,
(vi) rincer et sécher le substrat S 160,
(vii) déposer la couche barrière à la diffusion du métal de remplissage 170,
(viii) rincer et sécher le substrat S 180,
(ix) pré-mouiller le substrat S 190,
(x) remplir la cavité par électrodéposition du métal 200,
(xi) rincer et sécher le substrat S 210, et
(xii) recuire le substrat S 220.

Le procédé peut en outre comprendre une étape supplémentaire de recuit du substrat S entre l'étape de rinçage et séchage du substrat S 180 et l'étape de pré-mouillage du substrat S 190.

Par ailleurs, comme indiqué précédemment, les étapes de rinçage et séchage du substrat S 130, 160 et/ou180 peuvent être réalisées dans le même module que les étapes de dépôt 120, d'activation de la couche barrière à la diffusion du métal 150 et/ou de dépôt 170 respectivement.

Le procédé 100 peut alors se dérouler comme suit.

Au cours d'une première étape, un opérateur place une cassette comprenant une pluralité de substrats S, par exemple 25 plaques de silicium, dans le réceptacle R.

La suite du procédé 100 peut alors être intégralement automatisée, sans intervention de l'opérateur.

La cassette est ouverte selon des moyens usuels et le robot 80 saisit une plaque pour l'amener au module de pré-mouillage 10.

Le module de pré-mouillage 10 est de préférence ouvert et son support 4 en position haute, de manière à permettre l'insertion et le positionnement de la plaque sur le support 4. Avantageusement, le robot 80 centre la plaque sur le support 4.

Le support 4 fixe ensuite la plaque, par exemple en effectuant le vide, de manière à protéger sa face arrière et à garantir son maintien en position dans le module 10, avant d'être amené en position basse dans le module 10.

Puis le module 10 est fermé grâce au couvercle 3, et l'étape de pré-mouillage 110 peut avoir lieu.

A la fin de l'étape, l'eau déionisée est aspirée. Pour cela, selon une forme de réalisation, le tuyau est descendu du couvercle 3 de sorte que son extrémité libre se trouve adjacente à la face active de la plaque, à une distance de l'ordre de 0.1 mm à 3 mm, et l'eau déionisée est aspirée. Le tuyau est ensuite escamoté dans le couvercle 3, et le module 10 ouvert.

Le support 4 est alors remonté en position haute, de préférence au-dessus de l'ouverture et fait saillie en dehors du conteneur 2, et la plaque subit une étape de séchage par rotation du support 4 autour de son axe de symétrie.

Enfin, le support 4 libère la plaque, et le robot 80 peut venir la chercher et la transférer au module de dépôt de la couche diélectrique isolante.

Au cours d'une deuxième étape, la machine dépose alors la couche diélectrique isolante 120.

Pour cela, le robot 80 positionne la plaque sur le support 4, qui la fixe en position, avant d'être amené en position basse au fond 2a du module, comme indiqué plus haut. Le module de dépôt de la couche diélectrique isolante est alors fermé grâce au couvercle 3 et l'étape de dépôt de la couche diélectrique isolante peut avoir lieu.

Cette étape 120 est décrite en détails dans le document FR 2 943 688 au nom de la Demanderesse et ne sera donc pas davantage détaillée ici.

A la fin de l'étape, le bain chimique B est aspiré pour réutilisation ou remplacement, par exemple grâce au tuyau comme décrit précédemment. Les connectiques (i.e. les dispositifs de mise en contact électrique notamment) peuvent alors être déconnectées du support 4.

Le support 4 est alors remonté en position haute, de préférence au-dessus de l'ouverture, et la plaque subit une étape de rinçage et de séchage 130. Pour cela, la buse est amenée au-dessus de la plaque, de préférence dans une zone centrale de celle-ci, et envoie de l'eau déionisée (ou autre fluide de rinçage) sur la plaque. Celle-ci est ensuite mise en rotation de manière à évacuer l'eau déionisée dans la cuve externe et à sécher la plaque.

De manière optionnelle, le support 4 peut déjà être mis en rotation une première fois avant le rinçage à l'eau, de manière à évacuer le reste de bain présent en surface du substrat S dans la cuve.

Enfin, le support 4 libère la plaque, et le robot 80 peut venir saisir la plaque et la transférer au module de recuit 70.

Le robot 80 tend alors la plaque au robot interne 73, qui la saisit par la tranche et la place dans le module de recuit 70, sur la plaque formant source froide 71. Puis, comme indiqué plus haut, le conteneur 2 est fermé, l'atmosphère remplacée par un gaz inerte, et le robot interne 73 place alors la plaque sur la plaque formant source chaude 72 et la laisse chauffer 140 pendant une durée déterminée, généralement quelques minutes. Enfin, le robot interne 73 repositionne le substrat S sur la plaque formant source froide 71, l'atmosphère inerte est évacuée et le module 70 est rouvert. Le robot interne peut alors saisir la plaque et la tendre au robot 80, qui la saisit et la transfère alors au module d'activation de la couche barrière à la diffusion du métal 30.

Le module d'activation de la couche barrière à la diffusion du métal 30 fonctionne de manière similaire au module de dépôt de la couche diélectrique isolante 20, à l'exception de l'étape de process elle-même, au cours de laquelle la surface est activée en vue du dépôt subséquent de la couche barrière à la diffusion 40.

A la fin de l'étape de process 150, la plaque est également rincée et séchée, comme décrit précédemment.

Le robot 80 transfère alors la plaque au module de dépôt de la couche barrière à la diffusion du métal, qui fonctionne également de manière similaire au module de dépôt de la couche diélectrique isolante, à l'exception de l'étape de process elle-même, au cours de laquelle on dépose la couche barrière, conformément par exemple à la description des demandes WO 2011/039310 et WO 2011/029860, puis la plaque est rincée et séchée comme décrit précédemment.

Le robot 80 transfère ensuite la plaque au module de pré-mouillage, où elle subit un pré-mouillage de manière identique à ce qui a été décrit précédemment, avant d'être transférée par le robot 80 au module de remplissage.

Le module de remplissage fonctionne lui-aussi de manière similaire au module de dépôt de la couche diélectrique isolante, à l'exception de l'étape de process elle-même, au cours de laquelle le via est rempli par électrodéposition, avec ou sans dépôt préalable d'une couche de germination, par exemple conformément à la demande FR 10 54668 déposée le 11 juin 2010 au nom de la Demanderesse.

Toutefois, on notera que l'étape finale de rinçage et de séchage est optionnelle. En particulier, selon une forme de réalisation préférée, seule une étape de séchage par rotation du support 4 autours de son axe de symétrie lorsque celui-ci est ramené en position haute peut être réalisée.

Le robot 80 transfère alors la plaque au module de rinçage et séchage.

De préférence, le module de rinçage et séchage est ouvert et son support 4 est en position haute. Le robot 80 positionne alors la plaque sur le support 4, qui la fixe en position, avant d'être amené en position basse dans le module, comme indiqué plus haut. Optionnellement, le module de rinçage et séchage peut alors être fermé grâce au couvercle 3 et l'étape de rinçage et de séchage peut avoir lieu.

Au cours de cette étape, la buse est amenée, par exemple par le bras, au-dessus de la plaque, et envoie du fluide de rinçage, ici de l'eau déionisée, sur la face active de la plaque. La plaque est ensuite mise en en rotation autour de l'axe de symétrie du support 4, de manière à évacuer l'eau. Enfin, une autre buse est amenée au-dessus de la plaque et envoie un gaz inerte, par exemple de l'azote, sur la face active de la plaque, de préférence vers le milieu de celle-ci.

A la fin de l'étape, le support 4 est alors remonté en position haute et libère la plaque de manière à permettre au robot 80 de la saisir afin de la transférer au module de recuit.

Le module de recuit effectue alors un recuit de la plaque comme décrit auparavant.

Enfin, le robot 80 saisit la plaque dans le module de recuit et la replace dans la cassette, ou le cas échéant dans une nouvelle cassette.

Le procédé complet de métallisation dure globalement entre 1 h et 2h par plaque et consomme environ 1.2 L de bains chimiques B.

En comparaison, un procédé de traitement groupé (par « batch » en anglais), consistant à former par voie humide certaines des couches sur le substrat S (en particulier la couche barrière de diffusion au métal de remplissage notamment) permet également d'obtenir rapidement des substrats S partiellement métallisés. Néanmoins, ils ne peuvent être appliqués à l'ensemble des étapes du procédé de métallisation, puisqu'il n'est pas possible de réaliser les étapes de pré-mouillage (dans laquelle il est nécessaire de force de l'eau à entrer dans les cavités), de dépôt de la couche diélectrique isolante et de remplissage (qui requièrent des connectiques particulières) sur plusieurs substrats S plongés simultanément dans un même bain chimique B. Les machines associées sont en outre très encombrantes et requièrent des moyens de surveillance complexes en raison des volumes de bains chimiques B utilisés.

Au contraire, en traitant les substrats l'un après l'autre, une machine conforme à l'invention permet de réduire considérablement les quantités de consommables utilisées, et par voie de conséquence l'encombrement nécessaire et les besoins en surveillance des bains chimiques B, réduisant donc également les coûts de fabrication par substrat traité selon un procédé conforme à l'invention, et d'obtenir rapidement des substrats métallisés de bonne qualité.

## Revendications

1. Machine (1) adaptée pour métalliser une cavité d'un substrat semi-conducteur ou conducteur telle qu'une structure du type via traversant, selon un procédé de métallisation comprenant les étapes consistant à :
a) déposer une couche diélectrique isolante dans la cavité,
b) déposer une couche barrière à la diffusion du métal de remplissage,
c) remplir la cavité par électrodéposition d'un métal, de préférence du cuivre, et
d) effectuer un recuit du substrat,
ladite machine (1) comprenant une série de modules (10-60) en voie humide configurés pour effectuer les étapes a), b) et c) par voie humide dans un bain chimique (B) et au moins un module complémentaire (70) adapté pour effectuer l'étape d) de recuit du substrat (S), de sorte que la machine (1) est apte à réaliser l'intégralité du procédé de métallisation de la cavité,
la machine étant **caractérisée en ce que** le substrat (S) comprend une face active, sur laquelle est formée la cavité, et une face arrière opposée à la face active et chaque module en voie humide comprend un conteneur (2) destiné à contenir le bain chimique (B), au fond (2a) duquel est disposé horizontalement un support (4) destiné à recevoir la face arrière du substrat (S) de sorte que la face active dudit substrat (S) soit orientée vers le haut dans la direction opposée au fond (2a) du module.

2. Machine (1) selon la revendication 1, dans laquelle le support (4) comprend des aménagements pour maintenir le substrat (S) en position au cours du procédé de métallisation et/ou une protection adaptée pour protéger la face arrière du substrat (S).

3. Machine (1) selon la revendication 2, dans laquelle les aménagements et la protection sont formés par au moins un canal adapté pour faire le vide entre le support (4) et le substrat (S).

4. Machine (1) selon l'une des revendications 1 à 3, comprenant au moins un module de recuit (70) du substrat (S) et dans laquelle la série de modules par voie humide comprend:
- au moins un module de pré-mouillage (10) du substrat (S),
- au moins un module de dépôt de la couche diélectrique isolante (20),
- au moins un module de rinçage et de séchage (60),
- au moins un module d'activation de la couche barrière à la diffusion (30),
- au moins un module de dépôt de la couche barrière à la diffusion (40), et
- au moins un module de remplissage par électrodéposition d'un métal (60).

5. Machine (1) selon la revendication 4, dans laquelle les modules de pré-mouillage (10), de dépôt de la couche diélectrique isolante (20), de rinçage et de séchage (60), d'activation (30), de dépôt de la couche barrière à la diffusion (40) et de remplissage (40) comprennent chacun des moyens (6) adaptés pour déplacer verticalement le substrat (S) entre une position haute, dans laquelle le support (4) est adjacent à une ouverture (2c) du module (2) afin de permettre le placement du substrat (S) sur le support (4), et une position basse, dans laquelle le support (4) est baissé dans le module (2) de manière à permettre son traitement par voie humide.

6. Machine (1) selon l'une des revendications 4 ou 5, dans laquelle les modules de dépôt de la couche diélectrique isolante (20), les modules d'activation de la couche barrière à la diffusion (30), les modules de dépôt de la couche barrière à la diffusion (40) et/ou les modules de remplissage (50) comprennent en outre un dispositif de rinçage et de séchage du substrat.

7. Machine (1) selon l'une des revendications 4 à 6, dans laquelle les modules de pré-mouillage, de dépôt de la couche diélectrique isolante, d'activation, de dépôt de la couche barrière à la diffusion et de remplissage comprennent en outre au moins des moyens adaptés pour permettre l'évacuation au moins partielle du bain chimique (B), lesdits moyens comprenant un tuyau s'étendant depuis un couvercle (3) du module (2) adapté pour aspirer au moins partiellement le bain chimique (B), et/ou une buse adaptée pour aspirer au moins partiellement le bain chimique (B).

8. Machine (1) selon l'une des revendications 4 à 7, dans laquelle chaque module de dépôt de la couche diélectrique isolante comprend:
- un conteneur (2) destiné à contenir le bain chimique (B), ici un électrolyte, au fond (2a) duquel est disposé le support (4) configuré pour recevoir le substrat,
- une anode constituée d'un métal inerte et disposée dans le conteneur (2),
- un éclairage comprenant une source émettant des rayons lumineux et un moyen pour homogénéiser les rayons lumineux sur l'ensemble de la surface du substrat, de manière à activer la surface du substrat,
- une alimentation électrique comprenant des moyens de connexion au substrat et à l'anode pour polariser la surface du substrat à un potentiel électrique permettant la réaction électrochimique, et
- un joint d'étanchéité, adapté pour isoler l'alimentation électrique de l'électrolyte.

9. Machine (1) selon l'une des revendications 4 à 8, dans laquelle chaque module de remplissage comprend un support (4) configuré pour recevoir le substrat et un moteur adapté pour mettre le support (4) en rotation autour d'un axe central dudit support (4) pour évacuer une partie du bain chimique (B).

10. Machine (1) selon l'une des revendications 4 à 9, dans laquelle chaque module de remplissage est en outre adapté pour déposer sur la couche barrière à la diffusion une couche de germination formée dans le même métal que la couche de remplissage.

11. Machine (1) selon l'une des revendications 4 à 10, dans laquelle
- chaque module de remplissage comprend :
- un conteneur (2) destiné à contenir le bain chimique (B), ici un électrolyte, au fond (2a) duquel est disposé le support (4) configuré pour recevoir le substrat,
- une anode, constituée d'un métal inerte ou d'un métal identique à celui qui est déposé au cours du remplissage de la cavité,
- une alimentation électrique comprenant des moyens de connexion à la couche barrière de diffusion et à l'anode pour polariser la surface de la couche barrière de diffusion à un potentiel électrique permettant la réaction électrochimique, et
- un joint d'étanchéité, adapté pour isoler le l'alimentation électrique de l'électrolyte, et/ou
- chaque module d'activation et/ou chaque module de dépôt de la couche barrière à la diffusion comprend :
- un conteneur (2) destiné à contenir le bain chimique (B), au fond (2a) duquel est disposé le support (4) configuré pour recevoir le substrat,
- un premier chauffage, adapté pour chauffer le substrat à une température de l'ordre de 50°C à 80°C, de préférence 65°C, ledit premier chauffage pouvant être constitué par le support (4) configuré pour recevoir le substrat, et/ou un deuxième chauffage, adapté pour chauffer le bain chimique (B) active insertion dans le conteneur (2) à une température de l'ordre de 50°C à 80°C, de préférence 65°C,
- un émetteur d'ultrasons ou de mégasons, et
- un joint d'étanchéité, adapté pour isoler une zone périphérique du substrat du bain chimique (B), et/ou
- chaque module de pré-mouillage comprend :
- un conteneur (2) destiné à contenir le bain chimique (B), ici de l'eau déionisée, au fond (2a) duquel est disposé le support (4) configuré pour recevoir le substrat, et
- une pompe, adaptée pour faire le vide dans le conteneur (2).

12. Procédé de métallisation d'une cavité d'un substrat semi-conducteur ou conducteur telle qu'une structure du type via traversant, comprenant les étapes consistant à :
a) déposer une couche diélectrique isolante,
b) déposer une couche barrière à la diffusion du métal de remplissage,
c) remplir la cavité par électrodéposition d'un métal, de préférence du cuivre, et
d) effectuer un recuit du substrat,
**caractérisé en ce que** lesdites étapes sont intégralement réalisées avec une machine (1) selon l'une des revendications 1 à 11.

13. Procédé de métallisation selon la revendication 12, **caractérisé en ce qu'**il comprend successivement les sous-étapes suivantes :
(i) pré-mouillage du substrat,
(ii) dépôt d'une couche diélectrique isolante,
(iii) rinçage et séchage du substrat,
(iv) recuit du substrat,
(v) activation de la couche barrière à la diffusion du métal,
(vi) rinçage et séchage du substrat,
(vii) dépôt de la couche barrière à la diffusion du métal de remplissage,
(viii) rinçage et séchage du substrat,
(ix) pré-mouillage du substrat,
(x) remplissage de la cavité par électrodéposition du métal,
(xi) rinçage et séchage du substrat, et
(xii) recuit du substrat.

14. Procédé de métallisation selon la revendication 13, comprenant en outre une étape de recuit du substrat entre l'étape de rinçage et séchage du substrat (viii) et l'étape de pré-mouillage du substrat (ix).

15. Procédé de métallisation selon l'une des revendications 13 et 14, dans lequel les étapes de rinçage et séchage du substrat (iii), (vi) et/ou (viii) sont réalisées dans le même module que les étapes de dépôt (ii), activation (v) et/ou dépôt (vii) respectivement.

## Patentansprüche

1. Maschine (1), die geeignet ist, um eine Kavität eines Halbleiter- oder Leitersubstrats, wie eine Struktur in der Art einer Durchgangskontaktierung gemäß einem Metallisierungsverfahren zu metallisieren, das die folgenden Schritte umfasst:
a) Abscheiden einer isolierenden dielektrischen Schicht in die Kavität,
b) Abscheiden einer Schicht als Sperre für die Diffusion des Füllmetalls,
c) Füllen der Kavität durch Elektroabscheidung eines Metalls, vorzugsweise von Kupfer, und
d) Durchführen einer Temperung des Substrats, wobei die besagte Maschine (1) eine Reihe von Modulen (10-60) im Nassverfahren umfasst, die konfiguriert sind, um die Schritte a), b) und c) im Nassverfahren in einem chemischen Bad (B) durchzuführen, und zumindest ein ergänzendes Modul (70), das geeignet ist, um den Schritt d) zum Tempern des Substrats (S) durchzuführen, sodass die Maschine (1) imstande ist, das gesamte Verfahren der Metallisierung der Kavität durchzuführen,
wobei die Maschine **dadurch gekennzeichnet ist, dass** das Substrat (S) eine aktive Seite umfasst, auf der die Kavität gebildet wird, und eine Rückseite entgegengesetzt zur aktiven Seite, und jedes Modul im Nassverfahren einen Behälter (2) umfasst, der dazu bestimmt ist, das chemische Bad (B) zu enthalten, an dessen Boden (2a) horizontal ein Halter (4) angeordnet ist, der dazu bestimmt ist, die Rückseite des Substrats (S) aufzunehmen, sodass die aktive Seite des besagten Substrats (S) nach oben, in die entgegengesetzte Richtung zum Boden (2a) des Moduls ausgerichtet ist.

2. Maschine (1) nach Anspruch 1, wobei der Halter (4) Anordnungen zum Festhalten des Substrats (S) in der Position während des Verfahrens der Metallisierung und/oder einen Schutz umfasst, der geeignet ist, um die Rückseite des Substrats (S) zu schützen.

3. Maschine (1) nach Anspruch 2, wobei die Anordnungen und der Schutz durch zumindest einen Kanal gebildet werden, der geeignet ist, um ein Vakuum zwischen dem Halter (4) und dem Substrat (S) zu erzeugen.

4. Maschine (1) nach einem der Ansprüche 1 bis 3, zumindest ein Tempermodul (70) für das Substrat (S) umfassend, und wobei die Reihe von Modulen im Nassverfahren Folgendes umfasst:
- zumindest ein Modul zum Vorbenetzen (10) des Substrats (S),
- zumindest ein Modul zum Abscheiden der isolierenden dielektrischen Schicht (20),
- zumindest ein Modul zum Spülen und Trocknen (60),
- zumindest ein Modul zum Aktivieren der Schicht zum Sperren der Diffusion (30),
- zumindest ein Modul zum Abscheiden der Schicht zum Sperren der Diffusion (40), und
- zumindest ein Modul zum Füllen eines Metalls durch Elektroabscheidung (60).

5. Maschine (1) nach Anspruch 4, wobei die Module zum Vorbenetzen (10), zum Abscheiden der isolierenden dielektrischen Schicht (20), zum Spülen und Trocknen (60), zum Aktivieren (30), zum Abscheiden der Schicht zum Sperren der Diffusion (40) und zum Füllen (40) jeweils Mittel (6) umfassen, die geeignet sind, um das Substrat (S) vertikal zwischen einer oberen Position, in der der Halter (4) an eine Öffnung (2c) des Moduls (2) angrenzend liegt, um die Platzierung des Substrats (S) auf dem Halter (4) zu ermöglichen, und einer unteren Position zu bewegen, in der der Halter (4) in das Modul (2) abgesenkt wird, um dessen Behandlung durch Nassverfahren zu ermöglichen.

6. Maschine (1) nach einem der Ansprüche 4 oder 5, wobei die Module zum Abscheiden der isolierenden dielektrischen Schicht (20), die Module zum Aktivieren der Schicht zum Sperren der Diffusion (30), die Module zum Abscheiden der Schicht zum Sperren der Diffusion (40) und/oder die Module zum Füllen (50) darüber hinaus eine Vorrichtung zum Spülen und Trocknen des Substrats umfassen.

7. Maschine (1) nach einem der Ansprüche 4 bis 6, wobei die Module zum Vorbenetzen, zum Abscheiden der isolierenden dielektrischen Schicht, zum Aktivieren, zum Abscheiden der Schicht zum Sperren der Diffusion und Füllen darüber hinaus zumindest Mittel umfassen, die geeignet sind, um zumindest die teilweise Evakuierung des chemischen Bades (B) zu ermöglichen, wobei die besagten Mittel einen Schlauch umfassen, der sich vom Deckel (3) des Moduls (2) aus erstreckt, und geeignet ist, um das chemische Bad (B) zumindest teilweise abzusaugen, und/oder eine Düse, die geeignet ist, um das chemische Bad (B) zumindest teilweise abzusaugen.

8. Maschine (1) nach einem der Ansprüche 4 bis 7, wobei jedes Modul zum Abscheiden der isolierenden dielektrischen Schicht Folgendes umfasst:
- einen Behälter (2) der dazu bestimmt ist, das chemische Bad (B), hier ein Elektrolyt, zu enthalten, an dessen Boden (2a) der Halter (4) angeordnet ist, der konfiguriert ist, um das Substrat aufzunehmen,
- eine Anode, die aus einem Inertmetall gebildet wird, und im Behälter (2) angeordnet ist,
- eine Beleuchtung, eine Quelle zum Aussenden von Lichstrahlen umfassend, und ein Mittel zum Homogenisieren der Lichtstrahlen über die gesamte Oberfläche des Substrats, um die Oberfläche des Substrats zu aktivieren,
- eine Stromversorgung, Verbindungsmittel mit dem Substrat und der Anorde umfassend, zum Polarisieren der Oberfläche des Substrats mit einem elektrischen Potential, das die elektrochemische Reaktion ermöglicht, und
- eine Dichtung, die geeignet ist, um die Stromversorgung vom Elektrolyt zu isolieren.

9. Maschine (1) nach einem der Ansprüche 4 bis 8, wobei jedes Modul zum Füllen einen Halter (4) umfasst, der konfiguriert ist, um das Substrat aufzunehmen und einen Motor, der geeignet ist, um den Halter (4) um eine zentrale Achse des besagten Halters (4) in Drehung zu versetzen, um einen Teil des chemischen Bades (B) zu evakuieren.

10. Maschine (1) nach einem der Ansprüche 4 bis 9, wobei jedes Modul zum Füllen darüber hinaus geeignet ist, um auf der Schicht zum Sperren der Diffusion eine Keimschicht abzuscheiden, die aus demselben Metall wie die Füllschicht gebildet wird.

11. Maschine (1) nach einem der Ansprüche 4 bis 10, wobei
- jedes Modul zum Füllen Folgendes umfasst:
-- einen Behälter (2) der dazu bestimmt ist, das chemische Bad (B), hier ein Elektrolyt, zu enthalten, an dessen Boden (2a) der Halter (4) angeordnet ist, der konfiguriert ist, um das Substrat aufzunehmen,
-- eine Anode, die aus einem Inertmetall oder aus einem identischen Metall, wie jenem gebildet wird, das im Laufe des Füllens der Kavität abgeschieden wird,
-- eine Stromversorgung, Verbindungsmittel mit der Schicht zum Sperren der Diffusion und der Anode umfassend, zum Polarisieren der Oberfläche der Schicht zum Sperren der Diffusion mit einem elektrischen Potential, das die elektrochemische Reaktion ermöglicht, und
-- eine Dichtung, die geeignet ist, um die Stromversorgung vom Elektrolyt zu isolieren, und/oder
- jedes Modul zum Aktivieren und/oder jedes Modul zum Abscheiden der Schicht zum Sperren der Diffusion Folgendes umfasst:
-- einen Behälter (2), der dazu bestimmt ist, das chemische Bad (B) zu enthalten, an dessen Boden (2a) der Halter (4) angeordnet ist, der konfiguriert ist, um das Substrat aufzunehmen,
-- eine erste Heizung, die geeignet ist, um das Substrat auf eine Temperatur in der Größenordnung von 50°C bis 80°C, vorzugsweise 65°C zu erwärmen, wobei die besagte erste Heizung durch den Halter (4) gebildet werden kann, der konfiguriert ist, um das Substrat aufzunehmen, und/oder eine zweite Heizung, die geeignet ist, um das chemische Bad (B) durch aktives Einführen in den Behälter (2) auf eine Temperatur in der Größenordnung von 50°C bis 80°C, vorzugsweise 65°C zu erwärmen,
-- einen Ultra- oder Megaschallsender, und
-- eine Dichtung, die geeignet ist, um eine umlaufende Zone des Substrats vom chemischen Bad (B) zu isolieren, und/oder
- jedes Modul zur Vorbenetzung Folgendes umfasst:
-- einen Behälter (2), der dazu bestimmt ist, das chemische Bad (B), hier entionisiertes Wasser, zu enthalten, an dessen Boden (2a) der Halter (4) angeordnet ist, der konfiguriert ist, um das Substrat aufzunehmen, und
-- eine Pumpe, die angepasst ist, um ein Vakuum im Behälter (2) zu erzeugen.

12. Verfahren zum Metallisieren einer Kavität eines Halbleiter- oder Leitersubstrats, wie eine Struktur in der Art einer Durchgangskontaktierung, die folgenden Schritte umfassend:
a) Abscheiden einer isolierenden dielektrischen Schicht,
b) Abscheiden einer Schicht zum Sperren der Diffusion des Füllmetalls,
c) Füllen der Kavität durch Elektroabscheidung eines Metalls, vorzugsweise von Kupfer, und
d) Durchführen einer Temperung des Substrats, **dadurch gekennzeichnet, dass** die besagten Schritte vollkommen in der Maschine (1) nach einem der Ansprüche 1 bis 11 augeführt werden.

13. Verfahren zum Metallisieren nach Anspruch 12, **dadurch gekennzeichnet, dass** es nacheinander die folgenden Unterschritte umfasst:
(i) Vorbenetzen des Substrats,
(ii) Abscheiden einer isolierenden dielektrischen Schicht
(iii) Spülen und Trocknen des Substrats,
(iv) Tempern des Substrats,
(v) Aktivieren der Schicht zum Sperren der Diffusion des Metalls,
(vi) Spülen und Trocknen des Substrats,
(vii) Abscheiden der Schicht zum Sperren der Diffusion des Füllmetalls,
(viii) Spülen und Trocknen des Substrats,
(ix) Vorbenetzen des Substrats,
(x) Füllen der Kavität durch Elektroabscheidung des Metalls,
(xi) Spülen und Trocknen des Substrats, und
(xii) Tempern des Substrats.

14. Verfahren zum Metallisieren nach Anspruch 13, darüber hinaus einen Schritt zum Tempern des Substrats zwischen dem Schritt zum Spülen und Trocknen des Substrats (viii) und dem Schritt zum Vorbenetzen des Substrats (ix) umfassend.

15. Verfahren zum Metallisieren nach einem der Ansprüche 13 und 14, wobei die Schritte zum Spülen und Trocknen des Substrats (iii), (vi) und/oder (viii) im selben Modul ausgeführt werden, wie jeweils die Schritte zum Abscheiden einer isolierenden dielektrischen Schicht (ii), Aktivieren (v) und/oder Abscheiden (vii).

## Claims

1. Machine (1) suitable for plating a cavity of a semi-conductive or conductive substrate such as a through via structure, according to a plating process comprising steps consisting of:
a) depositing an insulating dielectric layer in the cavity,
b) depositing a layer forming a barrier to the diffusion of the filler metal,
c) filling the cavity by electrodeposition of a metal, preferably copper, and
d) annealing the substrate,
said machine (1) comprising a series of wet modules (10-60) configured to carry out steps a), b) and c) by wet process in a chemical bath (B) and at least one additional module (70) suitable for carrying out step d) of annealing the substrate (S), such that the machine (1) is capable of performing the entire cavity plating process,
the machine being **characterised in that** the substrate (S) comprises an active side, on which the cavity is formed, and a rear side opposite the active side, and **in that** each wet module comprises a container (2) intended to contain the chemical bath (B), at the bottom (2a) of which is horizontally positioned a support (4) intended to receive the rear side of the substrate (S) such that the active side of said substrate (S) is oriented upwards in the opposite direction to the bottom (2a) of the module.

2. Machine (1) according to claim 1, wherein the support (4) comprises fittings for holding the substrate (S) in position during the plating method and/or a protection designed to protect the rear side of the substrate (S).

3. Machine (1) according to claim 2, wherein the fittings and the protection are formed by at least one channel designed to aspirate between the support (4) and the substrate (S).

4. Machine (1) according to one of claims 1 to 3, comprising at least one annealing module (70) for annealing the substrate (S) and wherein the series of wet modules comprises:
- at least one pre-wetting module (10) for pre-wetting the substrate (S),
- at least one depositing module (20) for depositing the insulating dielectric layer,
- at least one rinsing and drying module (60),
- at least one activation module (30) for activating the diffusion barrier layer,
- at least one depositing module (40) for depositing the diffusion barrier layer, and
- at least one metal filling module (60) by electrodeposition.

5. Machine (1) according to claim 4, wherein the pre-wetting module (10), insulating dielectric layer depositing module (20), rinsing and drying module (60), activation module (30), diffusion barrier layer depositing module (40) and filling module (40) each comprise means (6) designed to vertically move the substrate (S) between a high position, wherein the support (4) is adjacent to an opening (2c) of the module (2) in order to allow the substrate (S) to be placed on the support (4), and a low position, wherein the support (4) is lowered in the module (2) so as to allow for its treatment by wet process.

6. Machine (1) according to one of claims 4 or 5, wherein the insulating dielectric layer depositing modules (20), the diffusion barrier layer activation modules (30), the diffusion barrier layer depositing modules (40) and/or the filling modules (50) further comprise a substrate rinsing and drying device.

7. Machine (1) according to one of claims 4 to 6, wherein the pre-wetting module, the insulating dielectric layer depositing module, the activation module, the diffusion barrier layer depositing module and the filling module further comprise at least means adapted to allow for the at least partial evacuation of the chemical bath (B), said means comprising a pipe extending from a cover (3) of the module (2) adapted to at least partially aspirate the chemical bath (B), and/or a nozzle adapted to at least partially aspirate the chemical bath (B).

8. Machine (1) according to one of claims 4 to 7, wherein each insulating dielectric layer depositing module comprises:
- a container (2) intended to contain the chemical bath (B), in this case an electrolyte, at the bottom (2a) of which is placed the support (4) configured to receive the substrate,
- an anode formed from an inert metal and placed in the container (2),
- a lighting comprising a light ray emitting source and a means for homogenising the light rays throughout the surface of the substrate, so as to activate the surface of the substrate,
- a power supply comprising connection means for connecting to the substrate and to the anode to polarise the surface of the substrate at an electric potential allowing for the electrochemical reaction to take place, and
- a seal, adapted to isolate the power supply from the electrolyte.

9. Machine (1) according to one of claims 4 to 8, wherein each filling module comprises a support (4) configured to receive the substrate and a motor adapted to set the support (4) in rotation around a central axis of said support (4) to evacuate part of the chemical bath (B).

10. Machine (1) according to one of claims 4 to 9, wherein each filling module is also adapted to deposit a germination layer on the diffusion barrier layer, said germination layer being formed in the same metal as the filling layer.

11. Machine (1) according to one of claims 4 to 10, wherein:
- each filling module comprises:
-- a container (2) intended to contain the chemical bath (B), in this case an electrolyte, at the bottom (2a) of which is placed the support (4) configured to receive the substrate,
-- an anode, formed from an inert metal or a metal identical to that deposited during the cavity filling process,
-- a power supply comprising connection means for connecting to the diffusion barrier layer and to the anode to polarise the surface of the diffusion barrier layer at an electric potential allowing for the electrochemical reaction to take place, and
-- a seal, adapted to isolate the power supply from the electrolyte.
- each activation module and/or each diffusion barrier layer depositing module comprises:
-- a container (2) intended to contain the chemical bath (B), at the bottom (2a) of which is placed the support (4) configured to receive the substrate,
-- a first heater, designed to heat the substrate to a temperature of about 50 °C to 80 °C, preferably 65 °C, said first heater capable of being formed by the support (4) configured to receive the substrate, and/or a second heater, adapted to heat the chemical bath (B), that is active and inserted into the container (2) to a temperature of about 50 °C to 80 °C, preferably 65 °C,
-- an ultrasonic or megasonic transmitter, and
-- a seal, adapted to isolate a peripheral area of the substrate of the chemical bath (B), and/or
- each pre-wetting module comprises:
-- a container (2) intended to contain the chemical bath (B), in this case deionised water, at the bottom (2a) of which is placed the support (4) configured to receive the substrate, and
-- a pump, adapted to aspirate inside the container (2).

12. Method for plating a cavity of a semi-conductive or conductive substrate such as a through via structure, comprising steps consisting of:
a) depositing an insulating dielectric layer,
b) depositing a layer forming a barrier to the diffusion of the filler metal,
c) filling the cavity by electrodeposition of a metal, preferably copper, and
d) annealing the substrate,
**characterised in that** said steps are entirely performed with a machine (1) according to one of claims 1 to 11.

13. Plating method according to claim 12, **characterised in that** it comprises the following successive sub-steps:
(i) the pre-wetting of the substrate,
(ii) the depositing of an insulating dielectric layer,
(iii) the rinsing and drying of the substrate,
(iv) the annealing of the substrate,
(v) the activation of the barrier layer to the diffusion of the metal,
(vi) the rinsing and drying of the substrate,
(vii) the depositing of the barrier layer to the diffusion of the filler metal,
(viii) the rinsing and drying of the substrate,
(ix) the pre-wetting of the substrate,
(x) the filling of the cavity by electrodeposition of the metal,
(xi) the rinsing and drying of the substrate, and
(xii) the annealing of the substrate.

14. Plating method according to claim 13, further comprising an annealing step for annealing the substrate between the substrate rinsing and drying step (viii) and the substrate pre-wetting step (ix).

15. Plating method according to one of claims 13 and 14, wherein the substrate rinsing and drying steps (iii), (vi) and/or (viii) are performed in the same module as the depositing step (ii), activation step (v) and/or depositing step (vii) respectively.
